(19) **Europäisches Patentamt European Patent Office Office européen des brevets**

(11) **EP 4 760 290 A1**

(12) **EUROPEAN PATENT APPLICATION**

(43) Date of publication:
**17.06.2026 Bulletin 2026/25**

(21) Application number: **24220322.2**

(22) Date of filing: **16.12.2024**

(51) International Patent Classification (IPC):
**G01R 31/367** (2019.01)     **G01R 31/389** (2019.01)
**G01R 31/392** (2019.01)     **H01M 10/48** (2006.01)

(52) Cooperative Patent Classification (CPC):
**G01R 31/392; G01R 31/367; G01R 31/389; H01M 10/48**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **CSEM Centre Suisse d'Electronique et de Microtechnique SA  - Recherche et Développement 2002 Neuchâtel (CH)**

(72) Inventor: **Gschwend, Grégoire 1223 Cologny (CH)**

(74) Representative: **e-Patent SA Rue Saint-Maurice 12 Case postale 2001 Neuchâtel 1 (CH)**

(54)     **METHOD OF DETERMINING THE STATE OF HEALTH OF A BATTERY**

(57)     Method of determining the state of health of a battery (1), comprising steps of:
- carrying out a full charging or discharging cycle on said battery (1), while taking voltage and current measurements, and generating an initial differential capacitance curve based on said voltage and current measurements;
- extracting $n$ values of differential capacitance at a plurality of voltages spaced at predetermined voltage intervals across a predetermined voltage range;
- fitting a model curve to said $n$ values of differential capacitance;
- integrating said model curve to obtain an initial capacity measurement;
- periodically, measuring differential capacitance at one of said predetermined voltages;
- updating said model curve based on said measured differential capacitance;
- integrating said updated model curve to obtain an updated capacity measurement;
- comparing said updated capacity measurement to said initial capacity measurement in order to determine said state of health.

101 → Generate $C_d(V)$

103 → Extract $n$ values of $C_d$ ; Generate $\{C_d(V_1), \dots, C_d(V_n)\}$

105 → Fit model to $\{C_d(V_1), \dots, C_d(V_n)\}$

107 → Calculate $Q_0$

109 → Measure $C_d(V_i)$ at voltage $V_i$

111 → Update model with new value of $C_d(V_i)$

113 → Calculate $Q_t$

115 → Calculate SoH

Figure 2

# Description

## Technical field

The present invention relates to the field of batteries. More particularly, it relates to the measurement of State of Health (SoH) of batteries.

## State of the Art

As rechargeable batteries become a greater feature of daily life in portable devices, vehicles, home or industrial energy storage etc., their management becomes ever more important. A particularly useful parameter used for battery management is the State of Health (SoH), which describes the ratio in capacity between a battery being tested and a fresh battery, considering cell aging. This is defined as the ratio of the maximum battery charge to its rated capacity, and is represented as a ratio according to the following equation:

$$SoH(t) = \frac{Q_t}{Q_0}$$

where $Q_t$ is the maximum charge available of the battery at time $t$, and $Q_0$ is the initial charge capacity when the cell is new.

The capacity is usually measured by integrating the current over the time required to fully discharge (or charge) the battery, or by integrating the differential capacitance $C_d$ of the battery over the full voltage range under consideration (which may for instance encompass the maximum and minimum voltages the cell will produce in use, may extend fully down to zero volts, or may be between a predetermined maximum and minimum voltages chosen at will), as follows:

$$Q_t = \int_{V_{min}}^{V_{max}} C_d(V)\, dV$$

Where V is the voltage, $V_{max}$ is the maximum voltage and $V_{min}$ is the minimum voltage. This does again require a complete charge or discharge between $V_{max}$ and $V_{min}$, in order to measure over the whole voltage range of interest. In terms of terminology, "differential capacitance" is the standard term used in the art, despite the fact that a chemical rechargeable battery is concerned, and not an electrostatic capacitor. Indeed, the units are coulombs per volt, also termed Farads, in the same way as for electrostatic capacitors.

While determining $Q_0$ on a new battery by measuring a full discharge curve is possible, it is not practical to repeat this measurement on a battery in use in order to obtain an accurate value of $Q_t$ and hence the SoH. With the increasing capacities of batteries, this would require taking the battery out of service and discharging significant amounts of charge, which takes a significant amount of time (several hours minimum), and can have a negative impact on battery life. Indeed, it typically requires discharging the battery under controlled conditions and is hence difficult, if not impossible, to carry out in-situ.

More practical solutions that can be used in-situ are Constant Current - Constant Voltage (CC-CV), Chronopotentiometry (CP) and Constant Current (CC) techniques. However, these techniques are difficult to apply in practice, since they must be performed over a relatively long time period. For instance, for CC-CV and CP, the terminal voltages must be maintained over several hours to allow the cell to fully relax, and for CC the current must be kept relatively low to avoid high polarisation.

The aim of the present invention is hence to at least partially overcome the limitations of the prior art.

## Disclosure of the invention

More precisely, the invention relates to a method of determining the state of health of a battery, as defined in claim 1. This method comprises steps of:

- carrying out a full charging or discharging cycle on said battery, while taking voltage and current measurements, and generating an initial differential capacitance curve based on said voltage and current measurements;
- extracting $n$ values of differential capacitance at a plurality of voltages spaced at predetermined voltage intervals, whether spaced regularly or irregularly, across a predetermined voltage range, which may for instance represent the permitted voltage range in use, the entirety of the voltage range from the maximum possible to zero, or any other predetermined range;
- fitting a model curve to said $n$ values of differential capacitance, e.g. by least-squares fitting a a polynomial based model, a Gaussian curve based model, a Frumkin isotherm based model, a Langmuir isotherm based model, or any other suitable model such as a Lorentzian function, Voigt profile or similar;
- integrating said model curve (over the entire curve) to obtain an initial capacity measurement;
- periodically, measuring differential capacitance at one of said predetermined voltages, e.g. by electrochemical impedance spectroscopy (EIS), direct charging/discharging or similar;
- updating said model curve based on said measured differential capacitance at the corresponding predetermined voltage;
- integrating said updated model curve (over the entire curve) to obtain an updated capacity measurement;
- comparing said updated capacity measurement to said initial capacity measurement in order to determine said state of health, e.g. by dividing the updated capacity measurement by said initial capacity measurement and expressing this as a decimal value, ratio, percentage or similar.

The steps starting from the step of "periodically, measuring differential capacitance at one of said predetermined voltages" are repeated at predetermined intervals, e.g. weekly, monthly, or according to any other desired regular or irregular schedule.

As a result, the model curve is updated point-by-point at intervals, so adapts to the ageing of the battery and enables accurate determination of the state of health in-situ without having to repeat a full charge and/or discharge cycle to update the differential capacitance curve. Each re-measured point only requires a few tens of minutes to obtain, rather than having to take the battery out of service potentially for hours and carrying out a full charge/discharge cycle, which also has a negative impact on battery life.

Advantageously, an initial open circuit voltage curve is determined from said model curve, and wherein an updated open circuit voltage curve is determined from said updated model curve. As is known in the art, this can be carried out by calculating the integral of the corresponding curve.

Advantageously, said step of measuring differential capacitance at one of said predetermined voltages is carried out by electrochemical impedance spectroscopy. For instance, this may be carried out by measuring an electrochemical impedance spectrum in a range from 500 mHz to 0.5 mHz, preferably in a range from 100 mHz to 1 mHz, with a fixed or variable frequency, i.e. generating a spectrum with one or more measurements at one or more frequencies.

Advantageously, said electrochemical impedance spectroscopy is carried out either in charging or discharging, with a predetermined amplitude and a direct current offset with a magnitude greater than or equal to said amplitude. This ensures that the EIS current signal does not cross the zero amps barrier, eliminating hysteresis and hence ensuring good measurement accuracy. For instance, this direct current offset may be in the range of 200 mA to 5 A, and/or in a C-rate range of C/50 to C/10, where C-rate is defined as the charge / discharge current divided by the nominally rated battery capacity.

Advantageously, said step of measuring differential capacitance at one of said predetermined voltages is carried out by direct charging or discharging around the predetermined voltage and passing through said predetermined voltage, which is simple to carry out but does not give as good results as EIS.

Advantageously, said step of measuring differential capacitance at one of said predetermined voltages is carried out on a random one of said predetermined voltages. Alternatively, this can be carried out on said predetermined voltages according to a predetermined sequence. Irrespective of which option is chosen, over time, every one of the $n$ measurements will be updated, leading to the model curve following the ageing of the battery.

The invention also relates to a system comprising a battery and a controller arranged to control charging and/or discharging of said battery, wherein said controller is adapted to carry out at least part of the steps of the method of any preceding claim. Indeed, the controller may be adapted to carry out the entirety of the steps of said method.

In the case in which the controller only carries out some of the steps of the method, it may be provided with a communications interface, either integrated in the controller or in communication therewith, in which case the controller is adapted to transmit said measured differential capacitance to a programmable computer (which may be standalone, a cloud computing solution or similar) via a communications interface, and at least said steps of:

- updating said model curve based on said measured differential capacitance;
- integrating said updated model curve to obtain an updated capacity measurement; and
- comparing said updated capacity measurement to said initial capacity measurement in order to determine said state of health,

are carried out on said programmable computer. The other method steps may be carried out in the controller or the programmable computer as appropriate.

**Brief description of the drawings**

Further details of the invention will become more apparent upon reading the detailed description, in reference to the annexed drawings, which illustrate:

- Figure 1: a generic schematic representation of a system upon which at least some of the steps of the method of the invention may be practiced;
- Figure 2: a schematic flow diagram of a method according to the invention;
- Figure 3: a graph of a model fitted to an number of values of differential capacitance measured at discrete, equally-spaced voltages;
- Figure 4: two graphs illustrating an EIS current curve and its impact on the measured voltage;
- Figure 5: a graph illustrating an updated set of differential capacitances measured at discrete, equally-spaced voltages; and
- Figure 6: a graph of an updated model fitted to the updated set of differential capacitances of figure 5.

**Embodiments of the invention**

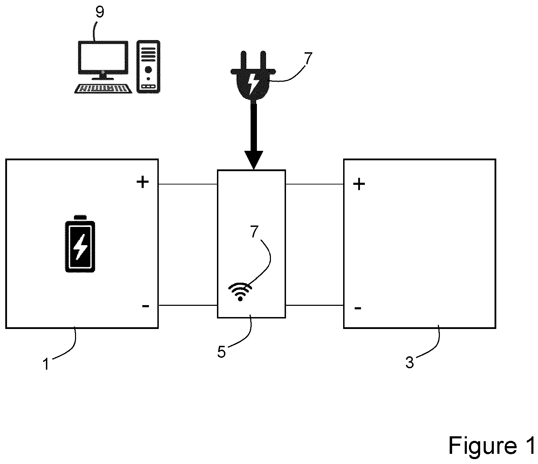

Figure 1 generically illustrates a system comprised of a rechargeable battery 1, such as a lithium ion, sodium ion, lead acid or any other type of rechargeable battery, the term "battery" being considered as synonymous with "cell". Battery 1 is arranged to power a device 3 of any convenient type, which may be a portable device (Smartphone, laptop computer, tablet, etc.), an electric vehicle, a hybrid vehicle, home or industrial appliances via a suitable interface, or similar. Battery 1 is associated with a controller 5, which is adapted to control the charging and discharging of the battery 1, charging taking place from an external power source 7 (grid electricity, solar panels, etc.) and/or by recuperation from the device 3, such as regenerative braking in the case of an electric or hybrid vehicle. Controller 5 may carry out part or the entirety of the method according to the invention, and may comprise, or be in communication with, a communications interface 7 adapted to communicate with at least one programmable computer 9, cloud computing solution or similar, part of the method being able to be carried out remotely on said programmable computer, cloud computing solution or similar, if desired.

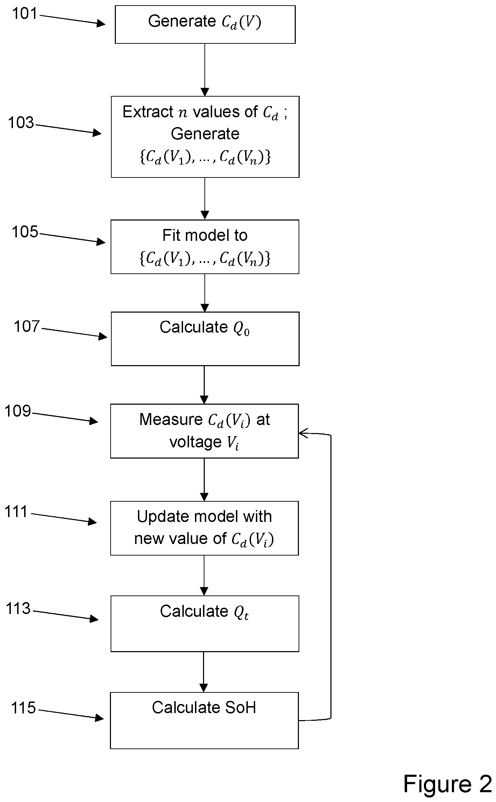

Figure 2 illustrates a flow diagram of the method of the invention.

In step 101, an initial differential capacitance curve $C_d(V)$ is measured over substantially the whole voltage range of the battery 1, typically by carrying out a full discharge cycle, although a full charge cycle or both are also possible. This is performed by charging or discharging the battery 1 while taking voltage and current measurements, from which the differential capacitance can be derived for the whole discharge curve, as is generally known.

In step 103, a number $n$ of differential capacitance values $C_d(V)$ are extracted from the full differential capacitance curve, at various voltages $V$ which are spaced at predetermined voltage intervals. Typically these predetermined voltage intervals are of equal voltage intervals, however this does not have to be the case. In practice, a value of $n$ between 20 and 30 is typical, but this may be more or less, according to needs, and can be optimised on the basis of the battery chemistry. This results in an initial set of differential capacitance values $\{C_d(V_1), \dots , C_d(V_n)\}$.

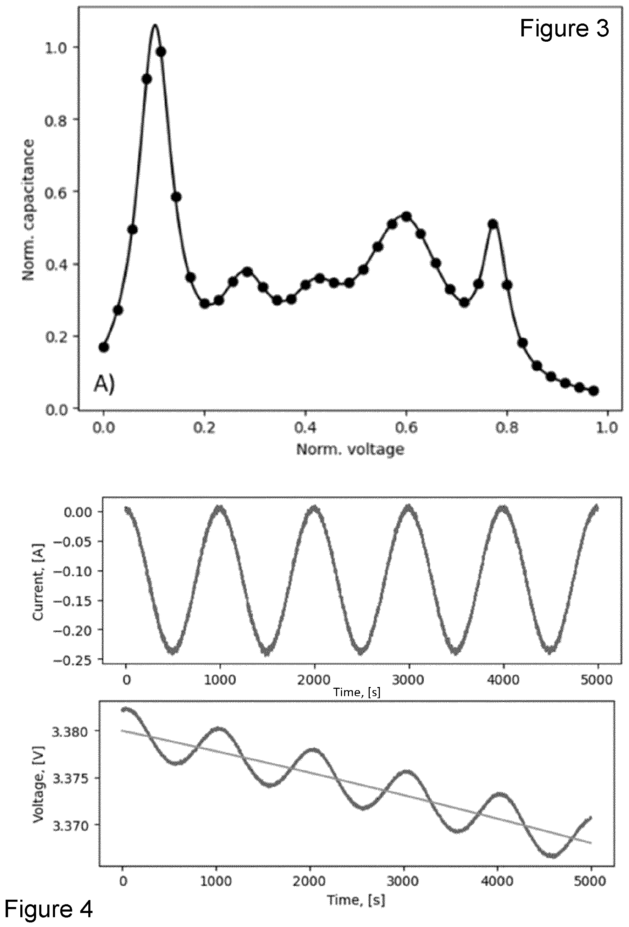

In step 105, a model curve is fitted (e.g. by least-squares fitting) to the n values in the initial set $\{C_d(V_1), \dots , C_d(V_n)\}$. An example of such a model curve $C_d'(V)$ is illustrated in Figure 3, in which the Y-axis represents the normalised differential capacitance measured at the normalised voltage values of the X-axis.

In step 107, the model curve is integrated to obtain an initial capacity estimate $Q_0$. This will later serve as the baseline for the SoH calculation.

For instance, this model could be fit by using six Frumkin isotherms:

$$C_d(V) = \sum_{i=1}^{i=6} \frac{A_i}{g_i + \frac{1}{V - V_i} + \frac{1}{1 - V + V_i}}$$

However, other models, such as a polynomial fit, several Gaussian curves, several skewed Gaussian curves, Langmuir or other isotherms, Lorentzian function, Voigt profile or any other convenient model, can be used.

Steps 101, 103, 105 and 107 can be considered as being an initiation phase, which may e.g. be carried out in a lab, factory or similar, though it may also be carried out in-situ on an installed battery 1.

The subsequent steps 109, 111, 113 and 115 may be considered as being an operational phase, carried out on the battery 1 in service.

In step 109, periodically, e.g. weekly, monthly, or at any convenient regular or irregular time intervals, the differential capacitance $C_d(V_i)$ is determined at one of the $n$ values of voltage $V$ upon which the model curve is based, the subscript $i$ indicating the one of the n values which is concerned.

Advantageously, this is carried out by electrochemical impedance spectroscopy (EIS) with a DC offset such that the current waveform of the EIS does not cross the zero amp value. This is carried out by the controller 5. An example of this in the context of EIS during discharge is illustrated in the upper graph of figure 4, which shoes the EIS current signal varying sinusoidally from a value of 0A to approximately -240 mA, with a frequency of 1 mHz (i.e. a time period of 1000 seconds) and an amplitude of 240 mA, though other offsets and amplitudes are naturally possible depending on the battery chemistry etc. Its effect on the voltage emitted by the battery 1 is illustrated in the lower graph of figure 4. The same principle for the can be applied in the charging case, in which the current signal remains positive, and the voltage will rise rather than fall. By not crossing the zero amp threshold, hysteresis in the battery's response is avoided. The frequency is typically within the range from e.g. 100 mHz to 1 mHz (but this could equally be from e.g. 500 mHz to 0.5 mHz or any other convenient values). EIS may be carried out at a single frequency, or at multiple frequencies, and may last from 5 minutes to 30 minutes, preferably 10 minutes to 20 mintues. An EIS range for lithium ion batteries is typically from 10 kHz to 1 mHz, and is usually caracterised by the number of frequencies per decade (typically 5 to 10 frequencies per decade, log-spaced) and a number of period per frequency (typically 5). The general principle of EIS and its application to calculate differential capacitance in rechargeable batteries is known in the art, see e.g. Muriel de Pauli, Aldo M.C. Gomes, Robson L. Cavalcante, Rafael B. Serpa, Carleane P.S. Reis, Françoise T. Reis, M. Luisa Sartorelli, Capacitance spectra extracted from EIS by a model-free generalized phase element analysis, Electrochimica Acta, Volume 320, 2019, 134366, ISSN 0013-4686, https://doi.org/10.1016/j.electacta.2019.06.059. In essence, by measuring how the battery voltage varies as a function of the EIS current waveform, the change in charge held by the battery (i.e. the integral of the current waveform) can be determined with respect to voltage, from which the differential capacitance $C_d(V)$ can be calculated in coulombs per volt. In the present application, frequencies typically lower than 1 Hz are used.

Although EIS is the preferred method for measuring $C_d(V)$, it is not the only possible method, others being e.g. discharging or charging at low and constant current around the one of the $n$ voltages under consideration, current pulses in either charge or discharge followed by a resting time, or similar.

The selection of one of the $n$ voltage values re-measured during this step can be random, or systematic. The aim is that over time, the model curve can be adapted to the ageing of the battery and hence to develop the whole model curve over time rather than just a reduced selection of the points.

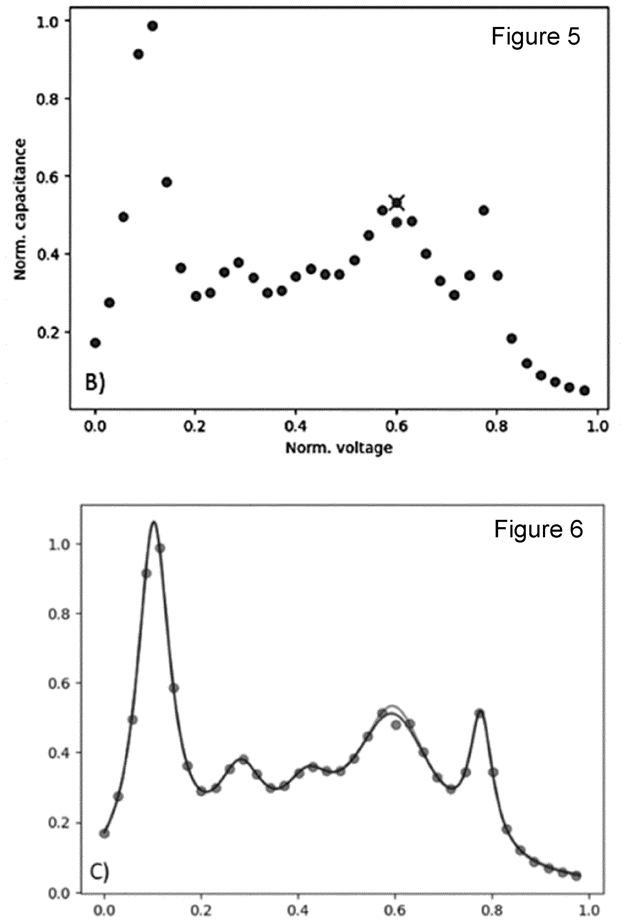

In step 111, the model is updated with the new value of $C_d(V_i)$ measured in step 109. This is illustrated in figures 5 and 6, in which figure 5 illustrates that the original value $C_d(V_i)$ (crossed out) at a normalised voltage of 0.6 has been replaced by a new, lower value as a result of the new measurement. The model is then re-fitted to the $n$ datapoints, as illustrated in figure 6, the lower curve having been re-fitted to account for the new value. As can clearly be seen, over time, the model curve will shift to fit to the progression of the various values of $C_d(V_i)$ as the battery 1 ages.

In step 113, and similarly to step 107, an estimate of the value of $Q_t$ is obtained by integrating under the model curve, and then this is used to calculate the SoH in step 115, namely by dividing $Q_t$ by $Q_0$.

Then, steps 109, 111, 113 and 115 are repeated after a predetermined time period has elapsed. This time period may for instance be a week, a month, or at any convenient time period, and the time period between repetitions of these steps may be equal or may vary.

It should also be noted that an open circuit voltage (OCV) discharge curve can be derived from the modelled $C_d(V)$ curve by integration of this latter, which can then be updated as the model is updated, eliminating the requirement to carry out a full discharge or charge cycle to obtain an updated OCV curve. This updated OCV discharge curve is then useful for other applications such as voltage response models of the battery, or SoC balancing algorithms.

In terms of operation of a system comprising at least battery 1 and controller 5, it is possible for all of the method steps to be carried out by the controller. However, it is also possible for steps 111, 113 and 115 to be carried out remotely, on a programmable computer 9 or cloud computing solution. Furthermore, the steps 103, 105 and 107 can be carried out remotely in the same manner. Essentially, the minimum for the controller to do in respect of the method is to control the charging and/or discharging, and to transmit the measurements obtained for processing elsewhere.

Although the invention has been described in terms of specific embodiments, variations thereto are possible without departing from the scope of the appended claims.

## Claims

1. Method of determining the state of health of a battery (1), comprising steps of:

   - carrying out a full charging or discharging cycle on said battery (1), while taking voltage and current measurements, and generating an initial differential capacitance curve based on said voltage and current measurements;
   - extracting $n$ values of differential capacitance at a plurality of voltages spaced at predetermined voltage intervals across a predetermined voltage range;
   - fitting a model curve to said $n$ values of differential capacitance;
   - integrating said model curve to obtain an initial capacity measurement;
   - periodically, measuring differential capacitance at one of said predetermined voltages;
   - updating said model curve based on said measured differential capacitance;
   - integrating said updated model curve to obtain an updated capacity measurement;
   - comparing said updated capacity measurement to said initial capacity measurement in order to determine said state of health.

2. Method according to claim 1, wherein an initial open circuit voltage curve is determined from said model curve, and wherein an updated open circuit voltage curve is determined from said updated model curve.

3. Method according to claim 1, wherein said step of measuring differential capacitance at one of said predetermined voltages is carried out by electrochemical impedance spectroscopy.

4. Method according to claim 3, wherein said electrochemical impedance spectroscopy is carried out by measuring an electrochemical impedance spectrum in a range from 500 mHz to 0.5 mHz, preferably in a range from 100 mHz to 1 mHz.

5. Method according to claim 4, wherein said electrochemical impedance spectroscopy is carried out with a predetermined amplitude and a direct current offset with a magnitude greater than or equal to said amplitude.

6. Method according to claim 5, wherein said direct current offset is in the range of 200 mA to 5 A, and/or in a C-rate range of C/50 to C/10.

7. Method according to any preceding claim, wherein said step of measuring differential capacitance at one of said predetermined voltages is carried out by direct charging or discharging.

8. Method according to any preceding claim, wherein said step of measuring differential capacitance at one of said predetermined voltages is carried out on a random one of said predetermined voltages.

9. Method according to any preceding claim, wherein said step of measuring differential capacitance at one of said predetermined voltages is carried out on a said predetermined voltages according to a predetermined sequence.

10. Method according to any preceding claim, wherein said model is chosen from:

    - a polynomial based model;
    - a Gaussian curve based model;
    - a Frumkin isotherm based model;
    - a Langmuir isotherm based model;
    - a Lorentzian function;
    - a Voigt profile.

11. System comprising a battery and a controller arranged to control charging and/or discharging of said battery, wherein said controller is adapted to carry out at least some of the steps of the method of any preceding claim.

12. System according to claim 11, wherein said controller is adapted to carry out the entirety of the steps of said method.

13. System according to claim 11, wherein said controller is adapted to transmit said measured differential capacitance to a programmable computer via a communications interface, and wherein at least said steps of:

    - updating said model curve based on said measured differential capacitance;
    - integrating said updated model curve to obtain an updated capacity measurement; and
    - comparing said updated capacity measurement to said initial capacity measurement in order to determine said state of health,

    are carried out on said programmable computer.

Figure 1

Figure 2

Figure 3

Figure 4

Figure 5

Figure 6

Europäisches
Patentamt

European
Patent Office

Office européen
des brevets

# EUROPEAN SEARCH REPORT

**Application Number**

EP 24 22 0322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/093809 A1 (YOSHITAKE SATOSHI [JP] ET AL) 30 March 2023 (2023-03-30) | 11,13 | INV. G01R31/367 |
| A | * abstract * * paragraph [0028] - paragraph [0097]; figures 1-14 * | 1-10,12 | G01R31/389 G01R31/392 H01M10/48 |
| | ----- | | |
| X | US 2023/014689 A1 (OGASAWARA KEISUKE [JP] ET AL) 19 January 2023 (2023-01-19) | 11,13 | |
| A | * abstract * * paragraph [0038] - paragraph [0135]; figures 1-12 * | 1-10,12 | |
| | ----- | | |
| X | US 2016/061908 A1 (TORAI SOICHIRO [JP] ET AL) 3 March 2016 (2016-03-03) | 11,13 | |
| A | * abstract * * paragraph [0071] - paragraph [0354]; figures 1-23 * | 1-10,12 | |
| | ----- | | |
| X | US 11 852 688 B2 (LG ENERGY SOLUTION LTD [KR]) 26 December 2023 (2023-12-26) | 11,13 | |
| A | * abstract * * column 5, line 12 - column 13, line 5; figures 1-6 * | 1-10,12 | **TECHNICAL FIELDS SEARCHED (IPC)** G01R H01M |
| | ----- | | |
| A | US 2023/280403 A1 (JEONG HEE-SEOK [KR] ET AL) 7 September 2023 (2023-09-07) * abstract * * paragraph [0106]; figure 3 * | 1-13 | |
| | ----- | | |
| A | HAO LIU ET AL: "Two points are enough", ARXIV.ORG, CORNELL UNIVERSITY LIBRARY, 201 OLIN LIBRARY CORNELL UNIVERSITY ITHACA, NY 14853, 19 August 2024 (2024-08-19), XP091857963, * the whole document * | 1-13 | |
| | ----- | | |
| | -/-- | | |

The present search report has been drawn up for all claims

| Place of search | Date of completion of the search | Examiner |
|---|---|---|
| Munich | 17 May 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

page 1 of 2

Europäisches
Patentamt
European
Patent Office
Office européen
des brevets

## EUROPEAN SEARCH REPORT

**Application Number**

EP 24 22 0322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | THELEN ADAM ET AL: "Integrating physics-based modeling and machine learning for degradation diagnostics of lithium-ion batteries", ENERGY STORAGE MATERIALS, vol. 50, 1 September 2022 (2022-09-01), pages 668-695, XP093258208, ISSN: 2405-8297, DOI: 10.1016/j.ensm.2022.05.047 * the whole document * | 1-13 | |
| A | SINA NAVIDI ET AL: "Physics-Informed Machine Learning for Battery Degradation Diagnostics: A Comparison of State-of-the-Art Methods", ARXIV.ORG, CORNELL UNIVERSITY LIBRARY, 201 OLIN LIBRARY CORNELL UNIVERSITY ITHACA, NY 14853, 5 April 2024 (2024-04-05), XP091721713, DOI: 10.1016/J.ENSM.2024.103343 * the whole document * | 1-13 | |
| A,D | DE PAULI MURIEL ET AL: "Capacitance spectra extracted from EIS by a model-free generalized phase element analysis", ELECTROCHIMICA ACTA, ELSEVIER, AMSTERDAM, NL, vol. 320, 14 June 2019 (2019-06-14), XP085779039, ISSN: 0013-4686, DOI: 10.1016/J.ELECTACTA.2019.06.059 [retrieved on 2019-06-14] * the whole document * | 1-13 | TECHNICAL FIELDS SEARCHED (IPC) |

The present search report has been drawn up for all claims

| Place of search | Date of completion of the search | Examiner |
|---|---|---|
| Munich | 17 May 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 24 22 0322

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2025

| Patent document cited in search report | | | Publication date | Patent family member(s) | | Publication date |
|---|---|---|---|---|---|---|
| US 2023093809 | A1 | | 30-03-2023 | CN | 115877216 A | 31-03-2023 |
| | | | | EP | 4166965 A1 | 19-04-2023 |
| | | | | JP | 7423583 B2 | 29-01-2024 |
| | | | | JP | 2023051292 A | 11-04-2023 |
| | | | | JP | 2024040204 A | 25-03-2024 |
| | | | | US | 2023093809 A1 | 30-03-2023 |
| US 2023014689 | A1 | | 19-01-2023 | CN | 115210593 A | 18-10-2022 |
| | | | | DE | 112020006860 T5 | 22-12-2022 |
| | | | | JP | 6918433 B1 | 11-08-2021 |
| | | | | JP | WO2021181536 A1 | 16-09-2021 |
| | | | | US | 2023014689 A1 | 19-01-2023 |
| | | | | WO | 2021181536 A1 | 16-09-2021 |
| US 2016061908 | A1 | | 03-03-2016 | CN | 105388422 A | 09-03-2016 |
| | | | | EP | 2990818 A2 | 02-03-2016 |
| | | | | US | 2016061908 A1 | 03-03-2016 |
| US 11852688 | B2 | | 26-12-2023 | CN | 112840221 A | 25-05-2021 |
| | | | | EP | 3913385 A1 | 24-11-2021 |
| | | | | ES | 2986504 T3 | 11-11-2024 |
| | | | | HU | E067676 T2 | 28-11-2024 |
| | | | | JP | 7151044 B2 | 12-10-2022 |
| | | | | JP | 2022510075 A | 26-01-2022 |
| | | | | KR | 20200131629 A | 24-11-2020 |
| | | | | PL | 3913385 T3 | 07-10-2024 |
| | | | | US | 2022075000 A1 | 10-03-2022 |
| | | | | US | 2024061050 A1 | 22-02-2024 |
| | | | | WO | 2020231086 A1 | 19-11-2020 |
| US 2023280403 | A1 | | 07-09-2023 | CN | 115917344 A | 04-04-2023 |
| | | | | EP | 4155748 A1 | 29-03-2023 |
| | | | | ES | 2991380 T3 | 03-12-2024 |
| | | | | HU | E068414 T2 | 28-12-2024 |
| | | | | JP | 7362990 B2 | 18-10-2023 |
| | | | | JP | 2023515595 A | 13-04-2023 |
| | | | | KR | 20220033350 A | 16-03-2022 |
| | | | | PL | 4155748 T3 | 16-12-2024 |
| | | | | US | 2023280403 A1 | 07-09-2023 |
| | | | | WO | 2022055264 A1 | 17-03-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MURIEL DE PAULI** ; **ALDO M.C. GOMES** ; **ROBSON L. CAVALCANTE** ; **RAFAEL B. SERPA** ; **CARLEANE P.S. REIS** ; **FRANÇOISE T. REIS** ; **M. LUISA SARTORELLI**. Capacitance spectra extracted from EIS by a model-free generalized phase element analysis. *Electrochimica Acta*, 2019, vol. 320, ISSN 0013-4686, 134366, https://doi.org/10.1016/j.electacta.2019.06.059